(19) Europäisches Patentamt
European Patent Office
Office européen des brevets

(11) **EP 2 416 191 A1**

(12) **EUROPEAN PATENT APPLICATION**

(43) Date of publication:
**08.02.2012 Bulletin 2012/06**

(51) Int Cl.:
**G02B 6/13** *(2006.01)*       *G02B 6/12* *(2006.01)*
**H01L 21/768** *(2006.01)*

(21) Application number: **11175688.8**

(22) Date of filing: **28.07.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **06.08.2010 US 852371**

(71) Applicant: **LSI Corporation
Milpitas, CA 95035 (US)**

(72) Inventors:
• **Delucca,, John
Wayne, PA Pennsylvania 19087 (US)**
• **Cargo, James
Bethlehem, PA Pennsylvania 18018 (US)**

(74) Representative: **Williams, David John
Page White & Farrer
Bedford House
John Street
London
WC1N 2BF (GB)**

(54) **Modification of semiconductor optical paths by morphological manipulation**

(57)     An optical device includes a substrate and a semiconductor layer located over the substrate. The optical path includes a semiconductor layer that further includes a waveguide core region. The core region includes a first semiconductor region with a morphology of a first type and a first refractive index. The first semiconductor region is located adjacent a second semiconductor region that has a morphology of a second type and a second refractive index that is different from the first refractive index.

EP 2 416 191 A1

## Description

This application is related to PCT Application No. PCT/US08/76976 filed by Frank A. Baiocchi, et al. on September 19, 2008, entitled "Allotropic Change in Silicon Induced by Electromagnetic Radiation for Resistance Tuning of Integrated Circuits", commonly assigned with this application and incorporated herein by reference; and co-pending United States Patent Application Serial No. 12/852,378 (attorney docket number L09-0675US1) filed by John DeLucca, et al., entitled "Modification of Logic by Morphological Manipulation of a Semiconductor Resistive Element", commonly assigned with this application and incorporated herein by reference.

## TECHNICAL FIELD

This application is directed, in general, to optical devices and, more specifically, to configuring optical paths.

## BACKGROUND

Opto-electronic and photonic devices include optical paths through which light signals travel. The optical characteristics of these paths, including refractive index (n) and extinction coefficient (k) determine the speed at which signals propagate, and the losses that result from propagation. The performance characteristics of the device depend in turn on the propagation speed and loss.

## SUMMARY

One embodiment provides an optical device that includes a substrate and an optical path located over the substrate. The optical path includes a semiconductor layer including a waveguide core region. The core region has a first semiconductor region with a morphology of a first type and a first refractive index. The first semiconductor region is located adjacent a second semiconductor region of the semiconductor layer that has a morphology of a second type and a second refractive index that is different from the first refractive index.

Another embodiment provides method of forming an optical device. The method includes providing a substrate having a semiconductor material layer located thereover that is configurable to receive an input optical signal. The material layer includes a region of the semiconductor material that has a morphology of a first type. The region is converted to a morphology of a second type that is different from the first type. The conversion changes a propagation characteristic of an optical path that includes the region.

## BRIEF DESCRIPTION

Reference is now made to the following descriptions taken in conjunction with the accompanying drawings, in which:

FIGS. 1A-1C illustrates an embodiment of an optical path that includes a first and a second morphology of a semiconducting material;
FIGs. 2A-2C illustrates an embodiment of a semiconductor layer in which a waveguide core region has a first morphology and a first refractive index, and a waveguide cladding region has a second different morphology and a lower refractive index;
FIG. 3 is a micrograph of a semiconductor layer after optical illumination;
FIG. 4 is a micrograph of an eFuse after being subjected to an electrical stress;
FIGs. 5A and 5B are micrographs of a sectioned eFuse after exposure to electrical stress similar to that experienced by the eFuse of FIG. 4;
FIG. 6 illustrates refractive index of c-Si, a-Si and p-Si as a function of wavelength;
FIG. 7 illustrates an optical resonator having a portion modified by optical heating;
FIG. 8 illustrates an optical resonator having eFuses configured to modify a portion thereof by electrical heating;
FIG. 9 illustrates an eFuse, an optical path and an intersecting portion configured to be heated;
FIG. 10 illustrates an interferometer having a portion thereof modified by optical heating;
FIG. 11 illustrates an interferometer having eFuses configured to modify a portion thereof by electrical heating;
FIGs. 12A-12E illustrate defining an optical path over a substrate by control of the morphology of portions of a semiconductor layer to form a waveguide core region;
FIGs. 13A-13C illustrate defining an optical path over a substrate by control of the morphology of portions of a semiconductor layer to form waveguide cladding regions; and
FIG. 14 is a method of the disclosure for forming an optical device, *e.g.* the optical device of FIGs. 1A-1C or the optical device 200 of FIGs. 2A-2C.

## DETAILED DESCRIPTION

This disclosure benefits from the recognition that optical properties of a semiconductor waveguide structure may be modified to alter the operation of an optical device that includes the waveguide structure. Some types of waveguides have been modified, e.g. using laser exposure, to form an optical element such as a Bragg grating. However, such modification has typically been limited to non-semiconducting optical waveguides such as optical fiber, LiNbO$_3$ and glass. The ability to modify a semiconductor waveguide structure as described in various embodiments herein provides a means to, e.g., rework, repair or tune the operating characteristics of an optical device that includes the semiconductor waveguide.

The disclosure presents various embodiments of optical devices that employ semiconductor materials for optical waveguides. Embodiments may refer to various semiconductor morphologies: bulk crystalline semiconductor, *e.g.* a portion of or extension of a crystalline semiconductor lattice, or an epitaxial layer; amorphous semiconductor, *e.g.*, having periodicity less than a few semiconductor bond lengths; and polycrystalline semiconductor, *e.g.*, having multiple crystalline domains that span more than a few tens (*e.g.* about 50) of semiconductor bond lengths with arbitrary orientation with respect to each other.

The disclosure contemplates embodiments practiced with each of the morphology types with any elemental or compound semiconductor, including without limitation Si, Ge, GaAs, InP, SiC, InGaP, InGaAs, and InAlGaP. The semiconductor may be doped or intrinsic. Various embodiments are described using Si as an example semiconductor material. Such use of Si as an example material does not limit the described embodiments to Si. Various embodiments may refer to amorphous Si as a-Si, crystalline Si as c-Si, and polycrystalline Si as p-Si. Those skilled in the pertinent art will appreciate that the principles illustrated by reference to these forms of Si may be extended to other semiconductors within the scope of the disclosure.

As used herein, allotrope refers to a form of a semiconductor material characterized by general bonding characteristics. Thus, the bulk crystalline and polycrystalline morphologies are both a same allotrope, because the semiconductor atoms are bonded in a crystalline arrangement. The amorphous morphology is a different allotrope, because the semiconductor bonds are in general not well-ordered as they are in a crystal. Various embodiments and claims may refer to an allotrope of a first type and an allotrope of a second type. The allotropes of the first and second types are mutually exclusive. Thus, the allotrope of a first type may refer to either crystalline morphology (bulk crystalline or polycrystalline) or to the amorphous morphology, while the allotrope of the second type then refers to the allotrope that is not the allotrope of the first type.

Various embodiments described herein include one or more regions of a semiconductor layer that may have a morphology selected from amorphous, polycrystalline and bulk crystalline. For example, without limitation, regions of a silicon layer may be amorphous silicon (a-Si), polycrystalline silicon (p-Si), or bulk crystalline silicon (c-Si). The description and the claims may refer to a morphology of a first type, a morphology of a second type, and a morphology of a third type. Each of the first, second and third morphology types may be any one of amorphous, polycrystalline or bulk crystalline. But within a single embodiment or claim, only one of the aforementioned morphologies, *e.g.*, amorphous, polycrystalline or bulk crystalline, may be uniquely assigned to each of the first, second and third types. Thus, for example, the morphology of the first type may be any of amorphous, polycrystalline or bulk silicon. The morphology of the second type may be any of the two remaining morphology types. The morphology of the third type is the remaining unassigned morphology type.

As used herein and in the claims, a semiconductor layer includes any homogeneous semiconductor stratum over a substrate, and semiconductor features that are derived from the homogeneous layer. The semiconductor layer explicitly excludes any additional material layer formed over the semiconductor layer, whether the additional layer is a semiconductor or other material. Thus, for example, an epitaxial layer over a handle wafer is a semiconductor layer, as are semiconductor features formed from the epitaxial layer, even if the features have a different morphology, or are noncontiguous. However, a semiconductor region overlying the homogeneous stratum, or features derived therefrom, is not included in the semiconductor layer. Such an excluded region typically can be identified by a discrete interface between it and the underlying homogeneous stratum or feature. Also excluded from the semiconductor layer is any semiconductor or other feature added after an isolated semiconductor feature is formed from the semiconductor layer. Thus, for example, if an isolated feature such as a waveguide core is formed from a semiconductor layer, material deposited over or adjacent to the waveguide core is not a part of the semiconductor layer, even if located on a same level as the waveguide core.

Focusing on silicon as an illustrative semiconductor material, during operation of a silicon photonic network, electromagnetic radiation propagates through various elements of the network. Silicon has a transmittance characteristic that is open to EM radiation (*e.g.* ≳ 50% transmittance) in the wavelength range of about 1.3 $\mu$m to about 6 $\mu$m. Thus, these wavelengths are commonly employed in silicon photonics. However, wavelengths shorter than 1.3 microns may have utility in some circumstances, such as in the case of attenuators or short propagation distances.

Each of the aforementioned morphologies generally may have a complex refractive index characteristic (refractive index, $n$, and extinction coefficient, $k$, that depends on wavelength. Moreover, electrical characteristics such as resistivity may be different for each of the morphologies. For example, at a wavelength of 1.12 $\mu$m, the refractive indices of c-Si and a-Si are reported in the open literature as 3.54 and 4.09, respectively. Because the speed of light in a medium depends on the refractive index of the medium, an optical signal is expected to travel more slowly through a-Si than through c-Si. As described further below, the difference of refractive index may be used to form a waveguide by manipulation of material morphology, to tailor the optical path length of a waveguide, or both.

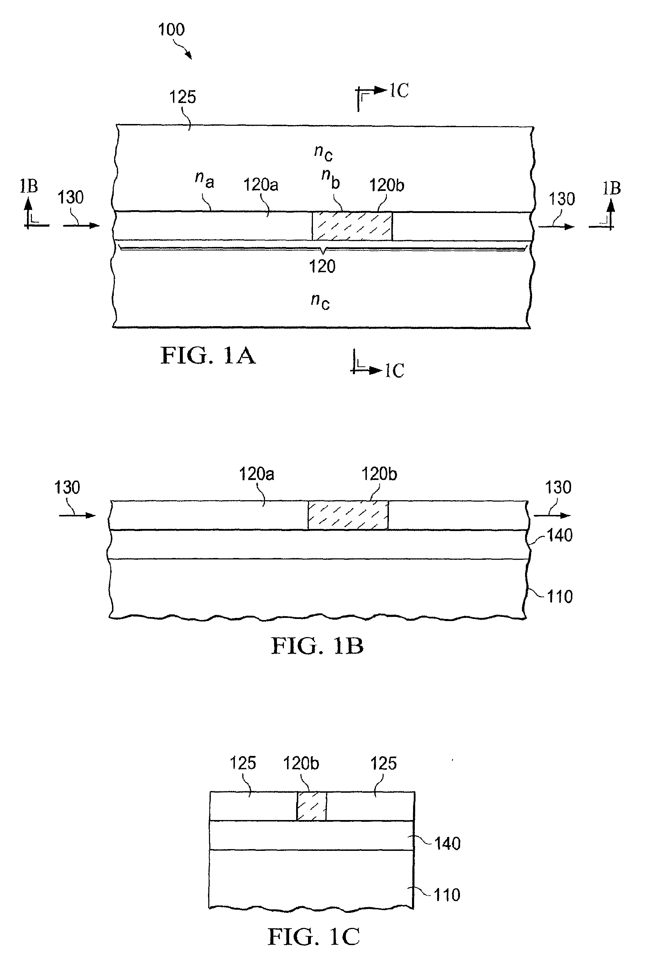

FIGs. 1A-1C illustrate plan (FIG. 1A) and sectional (FIGs. 1B and 1C) views of an optical device generally designated 100. The device 100 may be a photonics device, e.g. a device that performs optical processing of an optical signal 130. The device 100 may be or include, without limitation, an optical multiplexer, demultiplexer, an optical filter, an optical resonator, an optical processor, an optical waveguide, an optical MEMs (micro-electro-mechanical system) device such as a mirror array, or other similar optical components. The illustrated embodiment is presented as a nonlimiting example of the elements of an optical device that may appear in various embodiments.

A substrate 110 has a core region 120 located thereover. The core region 120 is configurable to receive the optical signal 130. The substrate 110 may be any suitable substrate, for example a wafer. The substrate 110 material may be a semiconductor such as silicon or germanium, but need not be. For example, a glass, quartz or sapphire substrate may be used.

The core region 120 may be formed from a homogeneous semiconductor layer. For example, a layer (not shown) that is initially a continuous stratum with uniform properties may be initially located over the substrate 110. In some embodiments the homogeneous layer may be patterned by selective removal of portions thereof to form the core region 120. In other embodiments, the core region 120 may be formed by altering morphological and/or optical properties of a portion of the homogenous layer by methods within the scope of the disclosure. The core region 120 may be configured to operate as a component of an optical path, e.g. as a planar waveguide core. A cladding region 125 is located adjacent the core region 120.

Herein, an optical path is a solid medium configured to constrain an optical signal, such as the optical signal 130, to propagate in the plane of the substrate 110. The optical path includes a core, e.g. the core region 130, and a cladding, e.g., the cladding region 125. The optical signal is generally guided in the direction of the core by total internal reflection at an interface between the core and the cladding. However, the disclosure contemplates embodiments in which the cladding has a refractive index that is greater than that of the core. Such embodiments may include cases in which, e.g. the optical path is configured to attenuate the optical signal.

The cladding region 125 is not limited to any particular material. The cladding region 125 may be or include, e.g., air, silicon oxide, or a semiconductor material. When the cladding region 125 is a semiconductor material it may be a portion of a same material layer from which the core region 120 is formed.

In some cases it may be desirable that the refractive index of the medium adjacent the core region 120 on all sides thereof is lower than that of the core region 120 to minimize loss of optical energy from the core region 120. Thus, a dielectric layer 140 that has a refractive index lower than the core region 120 may be located between the substrate 110 and the core region 120, thus acting as an under-cladding to the core region 120. The dielectric layer 140, if present, may be an oxide layer associated with a semiconductor-on-insulator (SOI) substrate, a thermal oxide, or a CVD oxide, or may be the substrate 110, e.g. a sapphire wafer.

The core region 120 includes a region 120a with a morphology of a first type and a first refractive index $n_a$, and a region 120b with a morphology of a second type and a second different refractive index $n_b$. An embodiment in which $n_b$ is greater than $n_a$ is considered without limitation. The optical signal 130 propagates at a greater speed through the region 120a than the region 120b. The propagation time of the optical signal 130 through the core region 120 depends on the relative lengths of the regions 120a and 120b along the optical path of the core region 120, such as in the direction of signal propagation. One or more of each of the regions 120a, 120b, of any desired combination of lengths, can be located along the path taken by the optical signal 130 through the core region 120.

The morphology of the semiconductor material layer from which the core region 120 is formed may be controllably modified in various embodiments. The modification may be performed to change the optical characteristics of the core region 120. In various embodiments changing the propagation characteristics may include changing a direction or speed of propagation, or changing the attenuation produced by the core region 120 on the optical signal 130, as described further below. Changing the propagation characteristics of the core region 120 may include changing a morphology of a material adjacent the core region 120. For example, the index of refraction of a portion of a semiconductor layer adjacent the core region 120, e.g., the cladding region 125, may be changed to increase or decrease the amount of the optical signal 130 that is lost from the core region 120 to the adjacent cladding region 125.

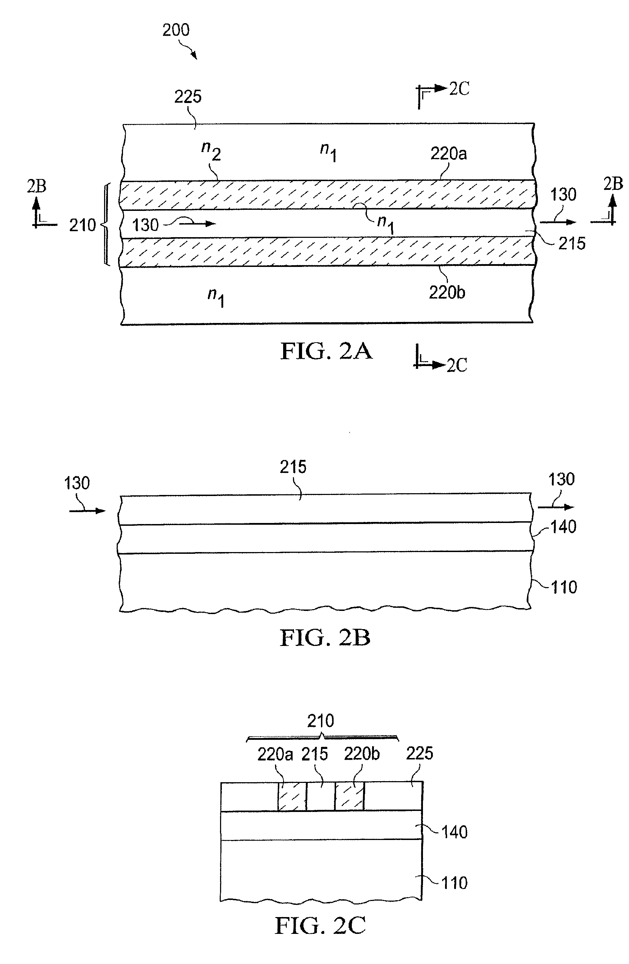

FIGs. 2A-2C illustrate a plan view (FIG. 2A) and sectional views (FIGs. 2B-2C) of an embodiment of an optical device generally designated 200. The device 200 includes a waveguide 210 that in turn includes a core region 215 and cladding regions 220a, 220b. A medium 225 may be, e.g., air, oxide, or a semiconductor material. In some embodiments the medium 225 is a portion of a continuous semiconductor material stratum formed over the substrate 110 from which the core region 215 and cladding regions 220a and 220b are formed. In the illustrated device 200, the core region 215 and the medium 225 have a refractive index $n_1$. Cladding regions 220a, 220b have a refractive index $n_2 < n_1$, thus confining a portion of the optical signal 130 to the waveguide 210.

PCT Application No. PCT/US08/76976 to Baiocchi, et al. (hereinafter referred to as "the '976 application"), previously incorporated by reference, discloses methods of changing the allotropic and/or morphological type of a semiconductor layer. In various embodiments described therein, coherent (laser) energy may be focused on a portion of a semiconductor layer, causing partial melting of the illuminated portion. For example, the energy dose and duration, focus, and time period over which multiple exposures are performed may determine a time-temperature profile that results in the formation of an amorphous or polycrystalline allotrope of the illuminated semiconductor. Thus, as described in the '976 application, a bulk crystalline or polycrystalline portion of a semiconductor, *e.g.*, silicon, may be controllably transformed to an amorphous allotrope, and then controllably changed to a polycrystalline allotrope. The conversion may be done without damage to surrounding dielectric layers or an underlying substrate.

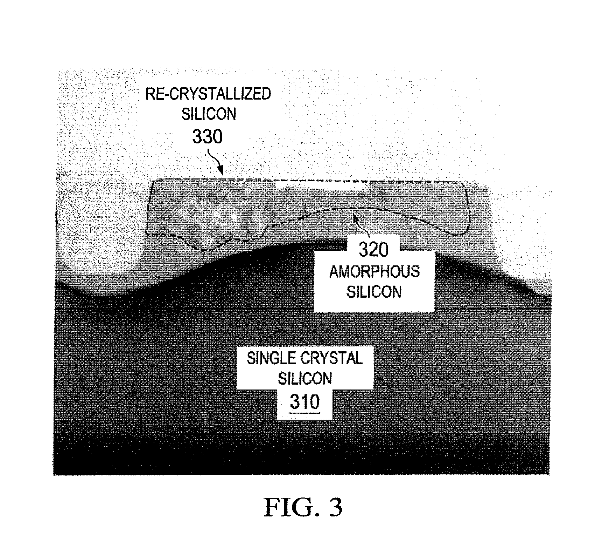

FIG. 3 illustrates a single-crystalline silicon substrate 310, a portion of which has been converted to an amorphous region 320 by illuminating the substrate 310 with laser light using a first pulse pattern and/or illumination condition. A portion of the amorphous region 320 has in turn been converted to a polycrystalline region 330 by illuminating the substrate 310 with laser light using a second pulse pattern and/or illumination condition. In general, the unaltered substrate 310, the amorphous region 320 and the polycrystalline region 330 each have different optical properties, and in particular, different indexes of refraction.

The present disclosure recognizes that the conversion of the semiconductor material from one morphology type to another morphology type may also be effected by heating a portion of the semiconductor material being converted using an electrical stimulus having appropriate characteristics. The stimulus may be, *e.g.* a current with a temporal profile configured to deposit a desired quantity of energy into a target region in which the conversion is desired over a desired time period. Thus, returning to FIG. 2A for example, the cladding regions 220a, 220b may be formed from a continuous semiconductor material stratum by controllably modifying the refractive index of the semiconductor material from an first, higher value to a second, lower value. In addition to the illumination heating described in the '976 application, in some embodiments the optical properties of a semiconductor material may be modified by an electrical stimulus, e.g. a current configured to heat a portion of the material.

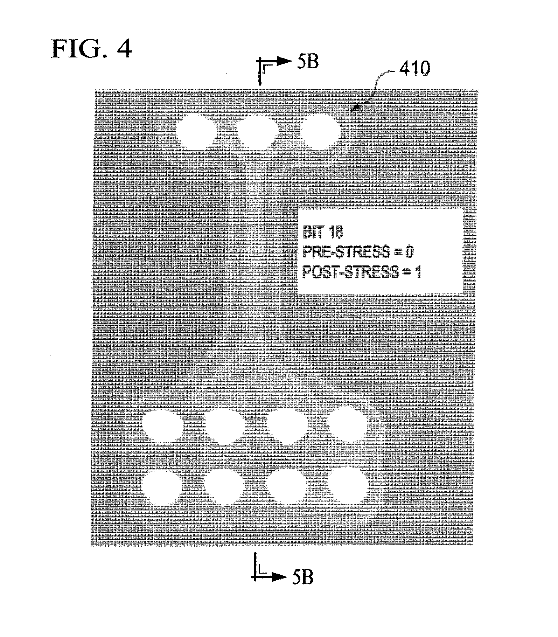

FIG. 4 illustrates an eFuse 410. The eFuse 410 was exposed to an electrical pulse typical of a Charged Device Model (CDM) Electrostatic Discharge (ESD) event. For example, such an event may be characterized by a voltage of 500 V at a current density on the order of $10^6$ A/cm$^2$ applied over a time period of about 1 ns. The eFuse 410 does not display visible evidence of programming, but the electrical properties are consistent with programming, *e.g.*, an increase of resistance. Thus, the eFuse 410 may be physically and electrically modified without visible damage thereto or to surrounding structure.

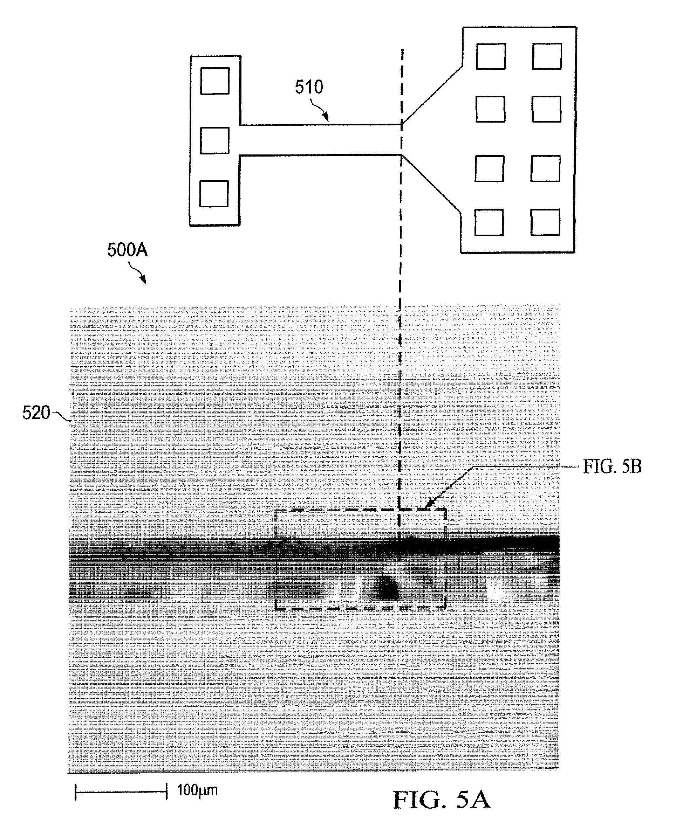

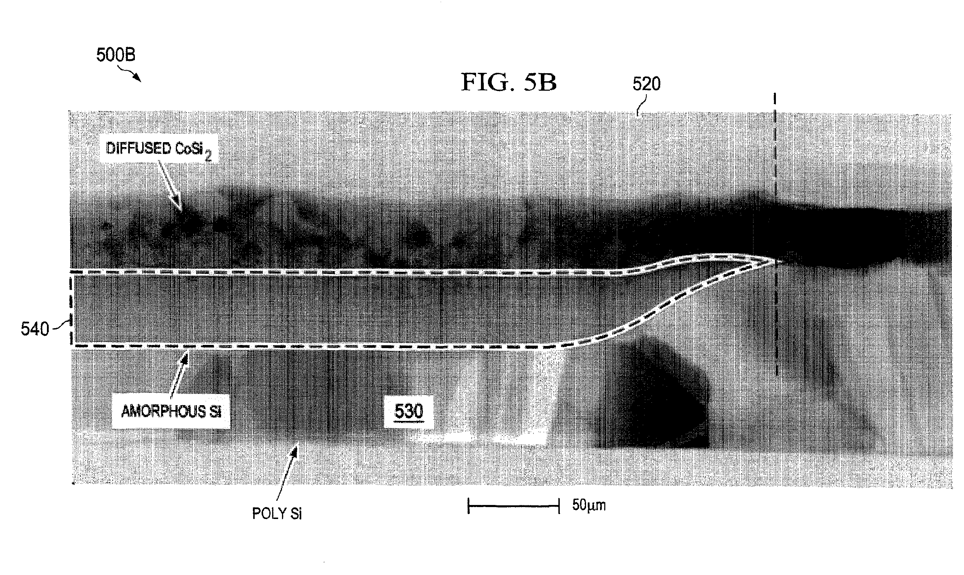

FIGs. 5A and 5B present TEM micrographs 500A (low magnification) and 500B (high magnification) of an eFuse 510 structure similar to that of the eFuse 410 after electrical stressing as described above. An oxide layer 520 is located over the eFuse 510. The eFuse 510, which originally was formed from p-Si, now includes a p-Si portion 530 and an a-Si portion 540. Little or no dimensional change to the eFuse 510 is apparent in spite of changing the morphology of the a-Si portion 540 from crystalline to amorphous. Notably, there is no evidence of damage to the oxide layer 520.

The observed alteration of properties, *e.g.* a change of electrical resistance with little or no observable damage to the eFuse 410 or surrounding material layers, may in various embodiments be obtained from a wide range of programming pulse characteristics. For example the pulse voltage may have a value that falls within a range between tens of volts and thousands of volts. Likewise, the pulse may have a duration in a range between sub-nanoseconds and microseconds. An effective combination of voltage and pulse duration is expected to depend on the specific layout of the structure to which the pulse is applied determinable by one skilled in the pertinent art. In various embodiments it may be advantageous to consider the resistance, capacitance, and inductance of the programmed structure. It is expected that the final properties of the programmed eFuse will correlate with total energy deposited into the eFuse. Thus it is expected that generally as the voltage of the programming pulse increases, the duration of the pulse will decrease, and vice-versa.

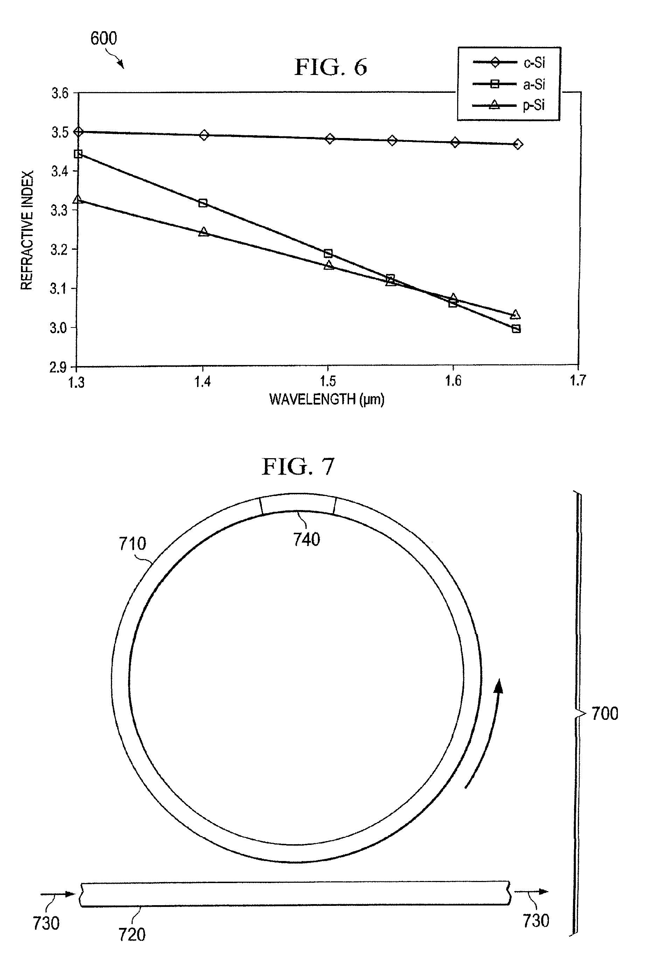

In various embodiments, the electrically-induced change of morphology evidenced in FIGs. 6A and 6B may be exploited in semiconductor photonic devices and networks. Electrodes may be placed in optical elements to apply a properly tailored electrical pulse to convert all or a portion of the optical element from a crystalline or polycrystalline morphology to an amorphous morphology, or from an amorphous morphology to a polycrystalline morphology. The conversion is expected to provide a means to change the optical and electrical properties of the semiconductor photonic element in a desired manner, providing a means for circuit design, rework, or trimming .

For example, FIG. 6 illustrates a plot generally designated 600 illustrating the relationship between the refractive indexes of c-Si, a-Si and p-Si as nonlimiting examples of morphologies of a semiconductor material for photonics applications. The refractive indexes are presented as a function of wavelength of light propagating through the material. These data are extrapolated from refractive index data in the open literature, and are presented without limitation as an example of the optical behavior of these morphologies of silicon.

In FIG. 6, c-Si is seen to have a refractive index greater than a-Si and p-Si for all wavelengths of the displayed range of wavelengths. Further, a-Si is seen to have a greater index of refraction than p-Si below about 1.58 μm, above which the order is reversed.

The relationships illustrated in FIG. 6 may be exploited in several ways. For example:

• An optical path initially including a c-Si segment may be altered to have a shorter optical path length by conversion of a portion of the c-Si segment to a-Si and/or p-Si.

• An optical path initially including an a-Si segment may be altered to have a shorter optical path length for wavelengths less than about 1.58 $\mu$m by conversion of a portion of the a-Si segment to p-Si. Above about 1.58 $\mu$m, the segment is expected to have a longer optical path length.

• An optical path initially including a p-Si segment may be altered to have a longer optical path length for wavelengths less than about 1.58 $\mu$m by conversion of a portion of the p-Si segment to a-Si. Above about 1.58 $\mu$m, the segment is expected to have a shorter optical path length.

• A silicon layer that is initially bulk crystalline (*e.g.* an epitaxial layer over a buried oxide layer) may have an optical path defined therein by conversion of a portion of the crystalline layer adjacent in intended core region to a-Si and/or p-Si.

Table I below compares scaled differences of the refractive index of a-Si relative to c-Si, p-Si relative to c-Si, and a-Si relative to p-Si, using values derived from FIG. 6. For both a-Si and p-Si, the difference of the refractive index relative to c-Si exceeds 1% for all wavelengths shown, and exceeds 10% for wavelengths of 1.55 $\mu$m and above. This relative difference of refractive index is expected to result in robust confinement of an optical signal in a waveguide constructed using these materials.

### TABLE I

| Wavelength ($\mu$m) | ($\alpha$-c) / c | (p-c) / c | ($\alpha$-p) / p |
|---|---|---|---|
| 1.3 | -1.7% | -5.2% | 3.7% |
| 1.4 | -5.0% | -7.3% | 2.5% |
| 1.5 | -8.5% | -9.5% | 1.1% |
| 1.55 | -10.2% | -10.6% | 0.4% |
| 1.6 | -12.0% | -11.7% | -0.3% |
| 1.65 | -13.8% | -12.9% | -1.0% |

The following embodiments illustrate various ways in which the optical properties may be modified using embodiments disclosed herein for converting a morphology of a semiconductor layer from a first to a second morphology. Those skilled in the pertinent art will recognize that other optical devices will similarly benefit from conversion of semiconductor morphology, and that such other optical devices are within the scope of this disclosure. Moreover, while the following embodiments may be described with respect to various morphologies of silicon, other embodiments using alternate semiconductor materials are also within the scope of the disclosure.

FIG. 7 illustrates a resonator generally designated 700 that includes a resonator ring 710 and an adjacent waveguide 720, each of which may be initially formed conventionally from p-Si. The waveguide 720 is located such that optical energy may be coupled from the waveguide 720 to the ring 710, and from the ring 710 to the waveguide 720. In various embodiments, the resonator 700 may be employed as a portion of a logical circuit element such as a logical AND and a logical NAND gate. Those skilled in the pertinent art are familiar with conventional implementations of these and similar devices using an optical resonator.

The ring 710 has a resonant frequency, on which the operating frequency of a circuit that includes the resonator 700 will depend in part. The resonant frequency is expected to be determined by several factors including the dimensions of the ring 710, the refractive index of the ring 710 medium, *e.g*, p-Si, the carrier concentration in the medium, and the intensity or power of an incident optical signal 730.

Various embodiments herein provide a means to adjust the resonant wavelength of the ring 710. In some embodiments, the adjusting is done using a coherent light source or an intense non-coherent light source as described in the '976 application. The ring 710 initially has an optical path length (OPL) equal to about the product of a circumference C ($\pi$*diameter in this example) and the refractive index, or

$$OPL = nC$$

The OPL may be adjusted by converting a segment 740 from p-Si to a-Si. In this case, the OPL of the ring 710 is expected to increase, resulting in a greater resonant wavelength of the ring 710 from $\lambda_1$ to $\lambda_2$. In another example, the resonator 700 is formed initially from a c-Si layer, such as an epitaxial layer. The segment 740 may be converted from c-Si to p-Si to reduce the OPL of the ring 710, thus reducing the resonant wavelength of the resonator 700 from an initial value $\lambda_3$ to a second value $\lambda_4$. A portion of the segment 740 may then be converted to a-Si, thereby increasing the OPL and increasing the resonant wavelength from $\lambda_4$ to another, intermediate value $\lambda_5$.

In this manner, the resonant wavelength of the ring 710 may be trimmed (tuned) to a specific desired value. Such trimming may be performed while the optical circuit of which the resonator is a part is operating. It is expected that in some cases the carrier concentration and mobility of the semiconductor material will be affected by the conversion of the material from one morphology to another. As a practical matter, it may be difficult to predict the precise resonant frequency that may result from such material property interactions. The ability to tune the resonator 700 provides a means to compensate for such changes in material characteristics to result in a precise desired value of resonant wavelength.

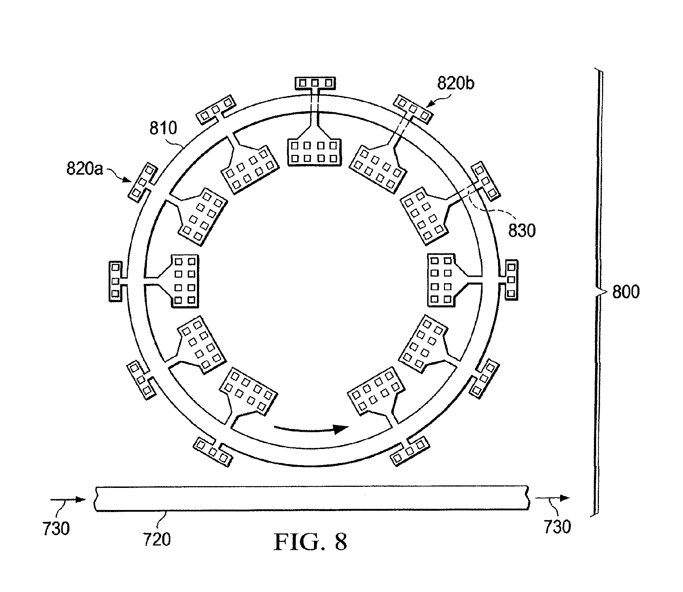

FIG. 8 illustrates an embodiment of a resonator 800 configured to be tuned using electrical fuse structures as heating elements. A resonator ring 810 includes several eFuse structures 820. The eFuse structures 820 are configured to heat a portion of the ring 810, thereby inducing a change of morphology of the heated portion.

In the embodiment of FIG. 8, the ring 810 includes eight unmodified eFuse structure 820a, and three modified eFuse structures 820b. Each modified eFuse structure 820b has an associated portion 830 of the optical path of the ring 810 that has been modified from a first morphology of the ring 810 as formed, to a second morphology with a different refractive index. As described with respect to the resonator ring 710, the morphology of the ring 810 and the portions 830 may be configured in various combinations to provide tunability of the resonant wavelength of the ring 810.

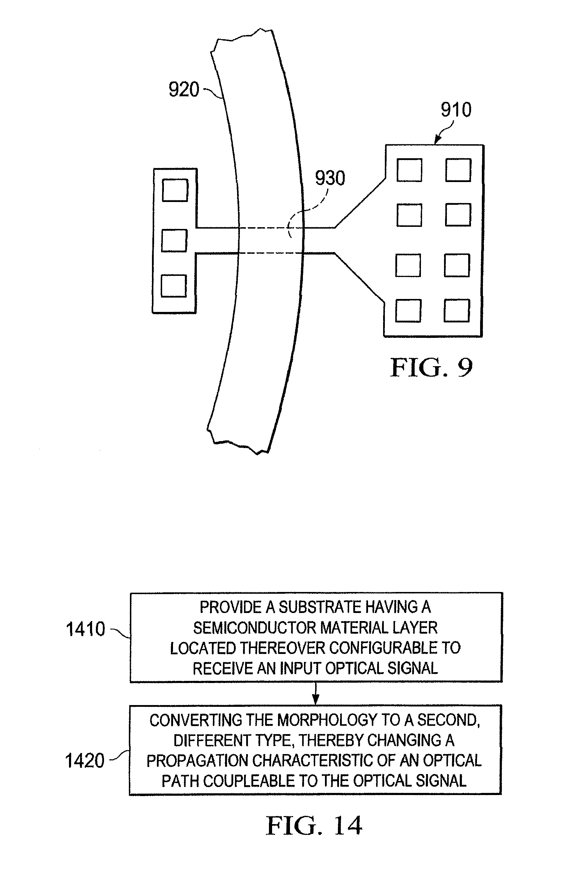

FIG. 9 illustrates an embodiment in which an eFuse 910 intersects a resonant structure 920 with an intersecting region 930. The resonant structure 920 may be, e.g., a resonator ring. In the illustrated embodiment the eFuse 910 and the resonant structure 920 are formed in a same semiconductor layer, *e.g.,* polysilicon. Portions of the eFuse 910 outside the region 930 are doped at a greater dopant concentration than is the resonant structure 920, including the region 930. The greater doping confers a greater conductivity to the eFuse 910 outside the region 930 than the resonant structure 920. During programming of the eFuse 910, e.g. alteration of the morphology of the intersecting portion 930, this configuration is expected to partially localize heating of the eFuse 910 to the region 930, thereby targeting the region 930 for conversion from one morphology to another. The localization of heating may advantageously increase the likelihood that the intended targeted layer will be converted from one morphology to another, and may also reduce the total power deposited into the device 100, thereby reducing the possibility of damage thereto.

In an alternate embodiment, a heating element, such as the region 930, may include one or more runners, *e.g.* conductive traces configured to route current thereto. In such embodiments, the runners replace the eFuse 910 outside the region 930. The thickness and/or width and/or composition of the runners may be selected to limit the resistance of the runners below a value at which significant heating of the runners would take place. The runners may be composed of an unmetalized or metalized semiconductor, such as silicon, *e.g.* silicided polysilicon, or of a reasonably refractory metallic material such as W, Ti, TiN, Ta, or TaN. Limiting the heating of the runners is expected to limit any chemical reaction of the runners or out-diffusion therefrom to an insignificant level. Here, insignificant reaction or diffusion means that no unacceptably detrimental effects to the device properties result from the programming process. The runners may connect to the region to be heated (*e.g.* the region 930) from the side, *e.g.* at the same level as the target region, or may be located above and below the target region and connected by a low-resistance connection such as one or more contacts or vias.

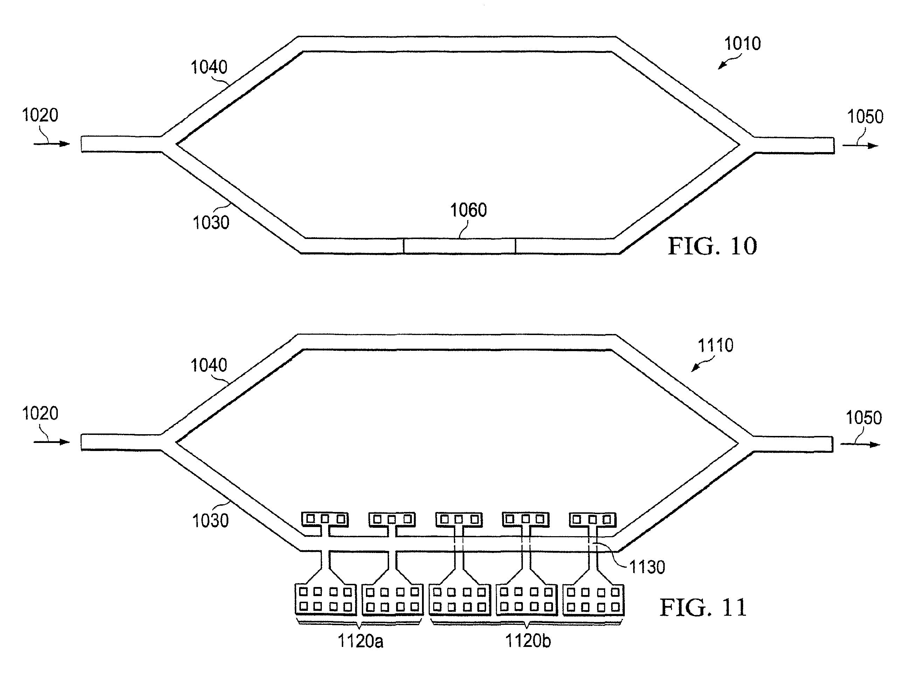

FIG. 10 illustrates an interferometer 1010, presented without limitation in a Mach-Zehnder configuration. The interferometer 1010 receives an input optical signal 1020, which is split between a first path 1030 and a second path 1040. The signal portions passing through the paths 1030, 1040 are recombined to produce an output signal 1050. In general the intensity and phase characteristics of the output signal 1050 depend on the relative phase delay of the signal portions that propagate through the paths 1030, 1040. The phase delay through each path 1030, 1040 in turn depends in part on the refractive index of the medium from which the paths 1030, 1040 are formed.

According to various embodiments described herein a segment 1060 of the first path 1030 may be modified from an initial first refractive index to a second refractive index. The modification may result from exposure to coherent or high-intensity light, *e.g.* In one embodiment, the segment 1060 is converted from p-Si to a-Si, thereby reducing the refractive index of the segment 1060. The OPL of the first path 1030 is thereby reduced, in turn reducing the phase delay imparted on the portion of the input optical signal 1020 propagating therethrough. As a result, the phase and intensity characteristics of the output signal 1050 are expected to change.

FIG. 11 illustrates an embodiment of an interferometer 1110 configured to be tuned by electrical eFuse structures 1120. The interferometer includes two unmodified eFuses 1120a. Three modified eFuses 1120b have been operated to modify the morphology of segments 1130 of the first path 1030. For example, the morphology may be changed from crystalline to amorphous. As before, the modification is expected to change the phase and intensity characteristics of the output signal 1050.

While various embodiments herein are described including two regions having different refractive indexes, embodiments of the disclosure are not limited thereto. Contemplated embodiments include those having three or more regions of different refractive indexes. Crystalline, amorphous or polycrystalline regions may be formed with a thickness determined to provide a desired average refractive index of each region. Thus, for example, one or more regions may be formed having a refractive index that is a weighted average of the refractive index of c-Si and of a-Si. The weighting of the refractive indexes of such regions may be determined by the relative proportions of the c-Si and a-Si in the region.

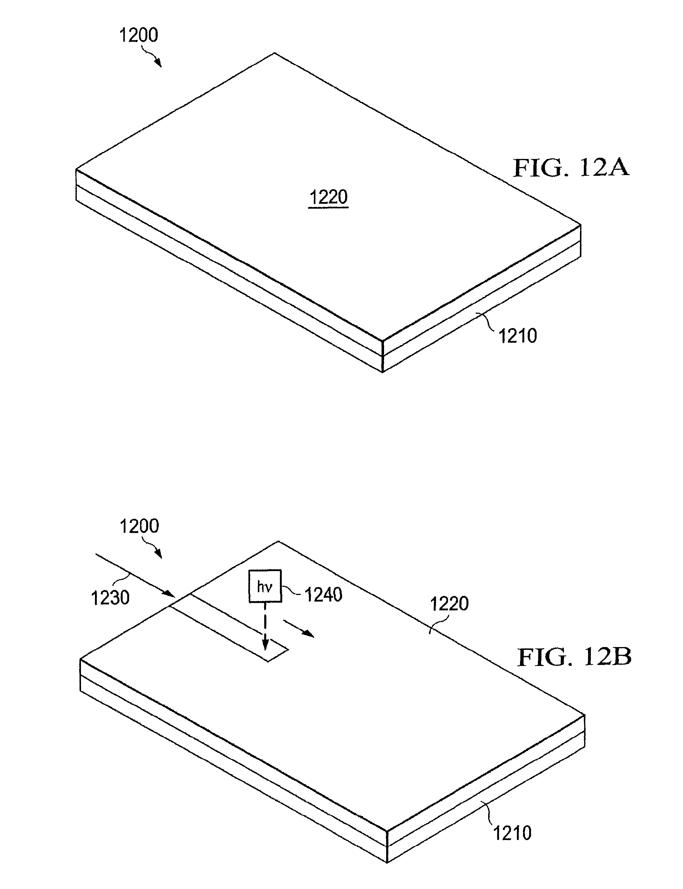

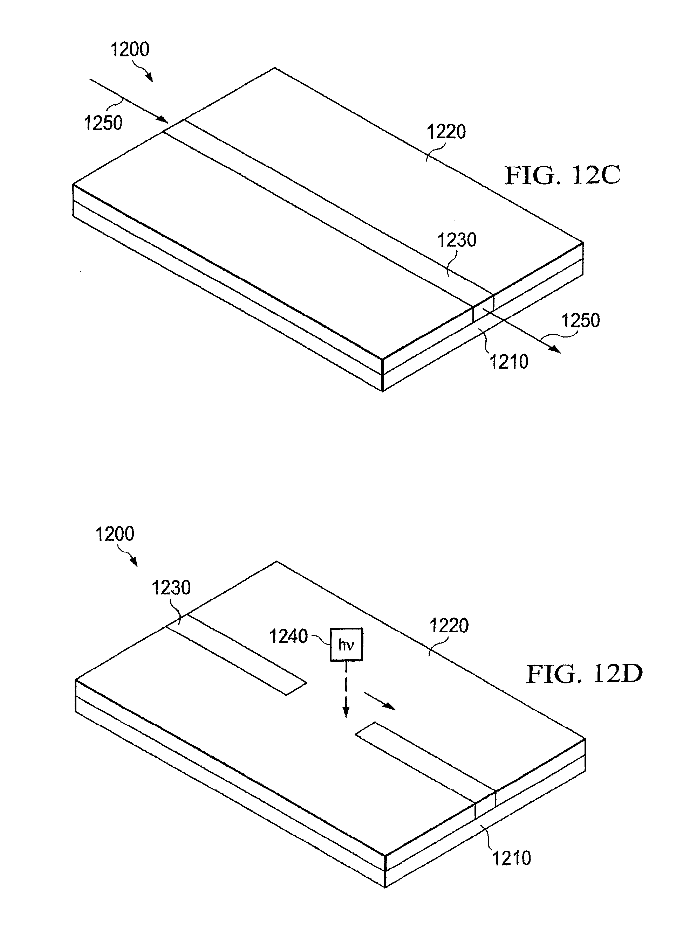

Turning to FIGs. 12A-12E, illustrated is an embodiment of a method 1200 of defining an optical path over a substrate 1210 by control of the morphology of portions of a semiconductor layer 1220. Additional process information is described in the '976 application. The layer 1220 is a first morphology of the semiconductor, *e.g.*, p-Si, and the substrate 1210 may be, *e.g.*, silicon dioxide. FIG. 12A illustrates the layer 1220 as initially formed, without a waveguide defined therein.

FIG. 12B illustrates forming a core region 1230 in the layer 1220. A light source 1240, *e.g.* a laser, scans across the layer 1220. The intensity, focus, duty cycle and illumination period may be controlled to convert the illuminated portion of the layer 1220 to a second different allotrope of the semiconductor from which the layer 1220 is formed. Thus, for example, the illuminated portion may be converted to a-Si. The illuminated portion then has a higher refractive index than the unilluminated layer 1220. The illuminated portion may thereby operate as the core region 1230 of a waveguide, with the adjacent unmodified layer 1220 operating as a cladding region.

FIG. 12D illustrates modification of the core region 1230 by subsequent illumination by the light source 1240. The light source 1240 may be operated with an intensity, focus, duty cycle and illumination period determined to convert an illuminated portion of the core region 1230 to p-Si. Because the layer 1220 is also p-Si, the illuminated portion of the core region 1230 has about the same refractive index as the layer 1220 and ceases to operate to confine the optical signal 1250. In other words, the illuminated portion of the core region 1230 is essentially erased.

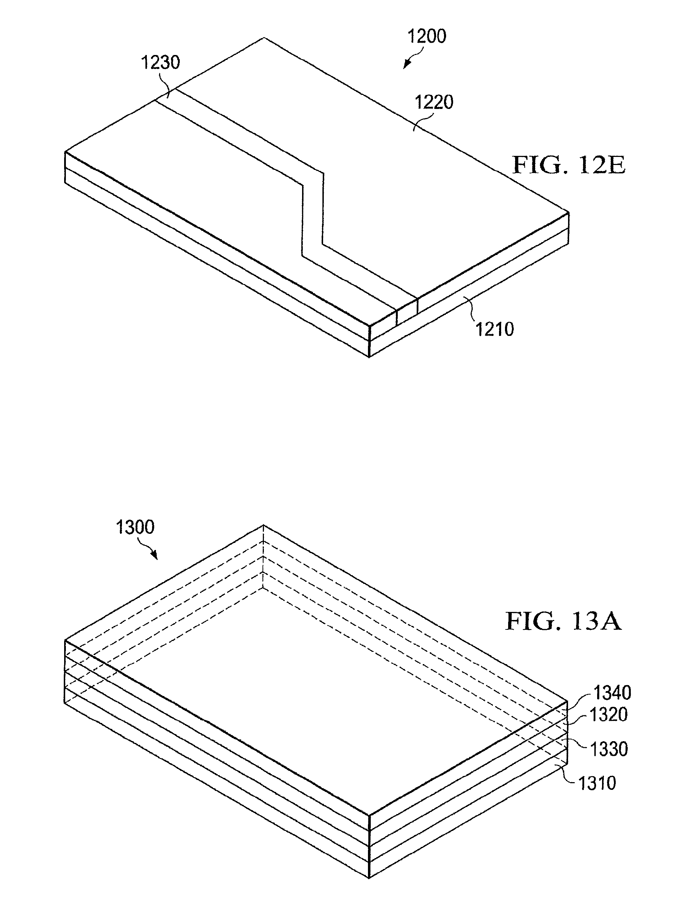

FIG. 12E illustrates the core region 1230 after additional illumination of the layer 1220, thereby forming a new portion of the core region 1230. The core region 1230 has thus been modified, or reworked, to have a different path. Such ability to modify the direction of an optical path in a photonic device provides a unique and innovative ability to rework a photonic device for, e.g., customizing functions, correcting layout errors, or repairing a damaged portion of the device.

FIGs. 13A-13C illustrate an embodiment of an optical device 1300 including an optical path formed over a substrate 1310. First considering FIG. 13A, in the illustrated embodiment a semiconductor layer 1320 is located over the substrate 1310, and a dielectric layer 1330 is optionally located therebetween. The semiconductor layer 1320 has an initial refractive index. A dielectric layer 1340 is located over the semiconductor layer 1320 as well. In some embodiments it may be preferred to locate an oxide layer over the semiconductor layer 1320 to protect the semiconductor layer 1320 from oxidation when heated to induce a change of morphology.

For example, the semiconductor layer 1320 may be c-Si as an epitaxial layer, with the dielectric layer 1330 being a buried oxide layer. The dielectric layer 1340 may be one or more layers of an interconnect dielectric stack, or may be an oxide layer formed over the semiconductor layer 1320 specifically to protect the semiconductor layer 1320.

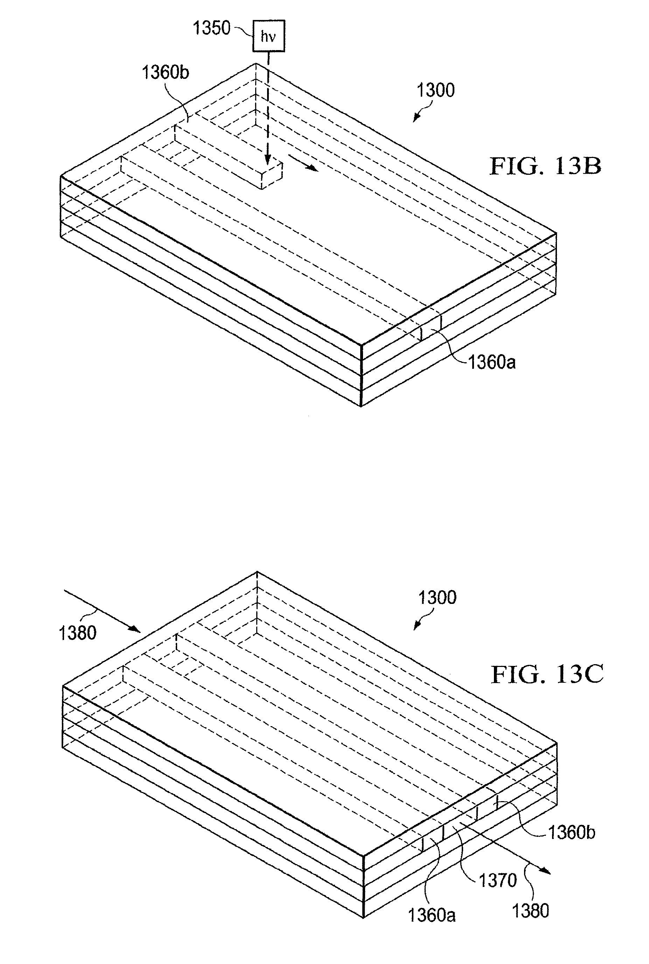

FIG. 13B illustrates forming an optical path by converting a portion of the semiconductor layer 1320 to a morphology with a modified refractive index lower than the initial refractive index. A light source 1350 heats a portion of the semiconductor layer 1320, thereby converting the heated portion to a morphology having the lower refractive index. One cladding region 1360a has been formed as illustrated, and another cladding region 1360b is being formed. The cladding regions 1360a and 1360b may act to confine an optical signal to a core region therebetween.

FIG. 13C illustrates the optical device 1300 after the portion 1360b has been formed. The portions 1360a, 1360b bound a core region 1370, in which an optical signal 1380 may be guided by virtue of the lower refractive index of the portions 1360a, 1360b, which act as cladding regions.

While various embodiments above are described with respect to the real portion, n, of the generally complex refractive index, it is also noted that the imaginary portion, or extinction coefficient $k$, of the complex refractive index will in general be different for different morphologies of a particular semiconductor. The extinction coefficient represents loss of a portion of the optical signal. Thus, the degree of loss, or attenuation, of the optical signal in an optical path may be modified by converting a portion of the optical path from one morphology to another morphology.

Modifying the attenuation provided by an optical path may be implemented in at least two ways. In a first method, a portion of an optical path such as the core region 120 (FIG. 1) is converted from one morphology with a first extinction coefficient $k_1$ to another morphology with a second different extinction coefficient $k_2$. In second method, a portion of a semiconductor, *e.g.* the cladding region 220b (FIG. 2) adjacent an optical path, *e.g.* the waveguide 210, is modified. The modification changes the degree to which the optical signal is confined within the waveguide. For example, if the waveguide 210 is c-Si and the cladding regions 220a, 220b are p-Si, the optical signal 130 is expected to be well-confined within the waveguide 210. If a sub-portion of the cladding region 220b is converted to a-Si, the refractive index of the sub-portion and the waveguide 210 will differ by only about 2% (see Table I). Thus, the optical signal 130 is expected to be less well-confined, and a portion of the signal is expected to be lost to the cladding region 220b. This second method provides an advantage over the first method in some cases in that less perturbation is expected of the wavelength-dependent propagation characteristics of the waveguide 210 than for the core region 120.

The embodiments described herein are not exclusive of embodiments of optical elements and devices within the scope of the disclosure. Those skilled in the pertinent art will appreciate that the principles demonstrated by the embodiments described can be applied to other semiconductor photonic devices. Optical network building blocks such as attenuators, waveguides, and electro-optic modulators may be formed by conversion of a semiconductor to a higher or lower refractive index allotrope or morphology. In particular, without limitation, electro-optic modulators are expected to realize significant benefit from the ability to tune or alter portions thereof using allotropic or morphological conversion, since such devices are often fabricated using a precisely tuned structure similar to a Fabry-Perot microcavity. Those skilled in the optical arts will appreciate that the resonant wavelength of a Fabry-Perot microcavity, and hence the transmittivity of the microcavity, is strongly dependent on the refractive index of the cavity medium. The resonant frequency of the cavity could be tailored to match a specific wavelength of incident radiation by converting a portion of the cavity from one Si allotrope to another.

Turning to FIG. 14, illustrated is a method, generally designated 1400, of forming an optical device. In a step 1410, a substrate is provided that has a semiconductor material layer located thereover. Herein and in the claims, "provided" means that a device, substrate, structural element, etc., may be manufactured by the individual or business entity performing the disclosed methods, or obtained thereby from a source other than the individual or entity, including another individual or business entity. The material layer is configurable to receive an input optical signal, and includes a region of the semiconductor material having a morphology of a first type.

In a step 1420 the region of the semiconductor material is converted to a morphology of a second type that is different from the first type. The converting may be by, e.g, illumination with electromagnetic radiation or electrical heating. The conversion changes a propagation characteristic of an optical path that includes the region. As described in various embodiments herein, the conversion of the morphology may be with respect to a portion of the semiconductor material of a waveguide core region or a waveguide cladding region adjacent to the core region.

Those skilled in the art to which this application relates will appreciate that other and further additions, deletions, substitutions and modifications may be made to the described embodiments.

**Claims**

1.  An optical device, comprising:

    a substrate;
    an optical path located over said substrate, said optical path including a semiconductor layer including a waveguide core region, said core region having a first semiconductor region with a morphology of a first type and a first refractive index, said first semiconductor region being located adjacent a second semiconductor region of said semiconductor layer that has a morphology of a second type and a second different refractive index that is different from said first refractive index.

2.  The optical device recited in Claim 1, wherein said first semiconductor region has a first allotropic state, and said second semiconductor region has a second allotropic state that is different from said first allotropic state.

3.  The optical device as recited in Claim 1, wherein said morphology of a first type is amorphous and said morphology of a second type is polycrystalline.

4.  The optical device recited in Claim 1, wherein said waveguide core region is a portion of a resonant optical path.

5.  The optical device as recited in Claim 1, further comprising a heating element configured to heat said waveguide core region.

6.  A method of forming an optical device, comprising:

    providing a substrate having a semiconductor material layer located thereover configurable to receive an input optical signal, said semiconductor material layer including a region of said semiconductor material having a morphology of a first type;
    converting said region to a morphology of a second type that is different from said first type, thereby changing a propagation characteristic of an optical path that includes said region.

7.  The method as recited in Claim 6, wherein said morphology of a first type is a first allotrope of said semiconductor material, and said morphology of a second type is a second allotrope of said semiconductor material that is different from said first allotrope.

8.  The method as recited in Claim 6, wherein said morphology of a first type is amorphous and said morphology of a second type is polycrystalline.

9.  The method as recited in Claim 6, wherein said region is located in an optical path of a waveguide ring.

10. The method as recited in Claim 6, wherein said converting results from optical illumination of said region.

FIG. 1A

FIG. 1B

FIG. 1C

200

225

$n_2$  $n_1$  220a

2B

210  130  $n_1$

2C

130

215

220b

$n_1$

**FIG. 2A**

2C

130

215

130

140

110

**FIG. 2B**

210

220a 215 220b 225

140

110

**FIG. 2C**

FIG. 3

FIG. 4

BIT 18
PRE-STRESS = 0
POST-STRESS = 1

500A

520

FIG. 5B

510

⊢————⊣ 100μm

FIG. 5A

500B

FIG. 5B

520

DIFFUSED CoSi$_2$

540

AMORPHOUS SI

530

POLY Si

50μm

EP 2 416 191 A1

## FIG. 6

## FIG. 7

FIG. 8

920

910

930

FIG. 9

1410 — PROVIDE A SUBSTRATE HAVING A SEMICONDUCTOR MATERIAL LAYER LOCATED THEREOVER CONFIGURABLE TO RECEIVE AN INPUT OPTICAL SIGNAL

1420 — CONVERTING THE MORPHOLOGY TO A SECOND, DIFFERENT TYPE, THEREBY CHANGING A PROPAGATION CHARACTERISTIC OF AN OPTICAL PATH COUPLEABLE TO THE OPTICAL SIGNAL

FIG. 14

FIG. 10

FIG. 11

EP 2 416 191 A1

1200

1220

1210

FIG. 12A

1200

1230

hv — 1240

1220

1210

FIG. 12B

FIG. 12C

FIG. 12D

1230

1200

1220

FIG. 12E

1210

1300

FIG. 13A

1340
1320
1330
1310

FIG. 13B

FIG. 13C

Europäisches
Patentamt

European
Patent Office

Office européen
des brevets

**EUROPEAN SEARCH REPORT**

Application Number

EP 11 17 5688

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/240821 A1 (VERNON STEVE [US] ET AL) 2 December 2004 (2004-12-02) * paragraph [0021] - paragraph [0025]; figure 2 * ----- | 1-10 | INV. G02B6/13 ADD. G02B6/12 H01L21/768 |
| X | US 2007/079750 A1 (MIGUEZ HERMAN [ES] ET AL) 12 April 2007 (2007-04-12) * paragraphs [0013], [0014], [0039]; claim 14 * ----- | 1-10 | |
| A | US 2002/090163 A1 (LIM DESMOND R [US] ET AL) 11 July 2002 (2002-07-11) * paragraph [0045] - paragraph [0053] * ----- | 4,5,9 | |
| A | WO 2010/033122 A1 (AGERE SYSTEMS INC [US]; BAIOCCHI FRANK A [US]; CARGO JAMES T [US]; DEL) 25 March 2010 (2010-03-25) * page 1, line 9 - line 11 * * page 6, line 16 - line 32 * ----- | 5,10 | |
| | | | TECHNICAL FIELDS SEARCHED (IPC) G02B H01L |

The present search report has been drawn up for all claims

| Place of search | Date of completion of the search | Examiner |
|---|---|---|
| The Hague | 9 November 2011 | Bourhis, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 11 17 5688

This annex lists the patent family members relating to the patent documents cited in the above-mentioned European search report.
The members are as contained in the European Patent Office EDP file on
The European Patent Office is in no way liable for these particulars which are merely given for the purpose of information.

09-11-2011

| Patent document cited in search report | | Publication date | Patent family member(s) | | Publication date |
|---|---|---|---|---|---|
| US 2004240821 | A1 | 02-12-2004 | NONE | | |
| US 2007079750 | A1 | 12-04-2007 | NONE | | |
| US 2002090163 | A1 | 11-07-2002 | US | 2002090163 A1 | 11-07-2002 |
| | | | US | 2004022474 A1 | 05-02-2004 |
| WO 2010033122 | A1 | 25-03-2010 | CN | 102203903 A | 28-09-2011 |
| | | | EP | 2340551 A1 | 06-07-2011 |
| | | | TW | 201029149 A | 01-08-2010 |
| | | | US | 2011163419 A1 | 07-07-2011 |
| | | | WO | 2010033122 A1 | 25-03-2010 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 0876976 W, Frank A. Baiocchi
- US 12852378 B